# EUROPEAN PATENT APPLICATION

(11) **EP 1 365 251 A2**
(43) Date of publication of application: **26.11.2003**
(21) Application number: 03253000.8
(22) Date of filing: 14.05.2003
(51) Int. Cl.: G01R 13/34

(54) **Dual time base digital storage oscilloscope**

(30) Priority: 22.05.2002 US 154613
(71) Applicant: Tektronix, Inc., Beaverton, OR 97077-0001 (US)
(72) Inventor: Dobyns, Kenneth P., Beaverton, Oregon 97007 (US)
(74) Representative: Burke, Steven David

(57) **Abstract**

A dual timebase feature for digital storage oscilloscope includes an A/D converter (400) for producing digital samples of a signal under test. The digital samples are applied to a first decimator (410) for decimating the samples. A second decimator (430) coupled to the output of the first decimator further decimates the samples. A pair of gates (435,437) selectively couples the outputs of the first and second decimators to a memory (420). A controller (440) controls one gate (435) to select a high data rate record having a length shorter than an entire data record for storage in memory and for display as a zoom (i.e. detailed) record, and controls the other gate (437) to select a low data rate record encompassing substantially all of said entire data record, for display as an overview record. The subject apparatus produces two data records of different data rates and encompassing different time periods.

## Description

### Field of the Invention

The subject invention generally concerns the field of dual-time base operation in an oscilloscope, and specifically addresses the field use of decimation circuitry for use in a dual time base mode of operation.

### Background of the Invention

Dual-time base operation is a desirable feature in a digital storage oscilloscope. This feature allows a user to examine a portion of an acquired data record in great detail. That is, one may select a portion (i.e., subset) of an acquired data record, and expand it on-screen to see more of the detail.

A variety of methods have been used to implement this capability in the prior art. In digital storage oscilloscopes, this feature has been realized by use of one of two methods, zoom or dual decimation.

When using the zoom method, a single acquisition data record is acquired that covers the timeframe visible on screen. This data record is acquired at a higher sample rate than is necessary when viewing the entire record, so that there is sufficient resolution to accurately display the "zoomed" portion of the data record. Unfortunately, this results in a large number of acquisition data samples for each pixel column of the display screen. That is, the level of detail with which a data record can be examined is dependent upon the number of data samples that have been acquired in each pixel column. Therefore, large zoom factors require long record lengths, which can be expensive to implement. In addition, the zoom method provides relatively slow update rates due to the necessity of processing all of the acquired samples for display of an overview record. That is, there are two distinct problems with the zoom method, slow drawing speed for an overview record and requirement for a large amount of memory to store all of the acquired samples.

In order to solve the first problem, slow drawing speed for the overview record, some prior art digital storage oscilloscopes employ an arrangement of two decimators to acquire two data records for display, a low resolution overview record and a high resolution zoom record.

One arrangement of two decimators, as known from the prior art, is parallel decimation (to be described below). Parallel decimation provides a low-resolution overview signal for rapid display, and a high-resolution signal for subsequent panning and zooming. Unfortunately, this solution requires the use of two complete decimators, and is therefore costly to implement.

A serial decimation arrangement (also to be further described below) is also directed to solving the problem of slow display of an overview record. This arrangement is known, for example, from U.S. Patent 5,790,133 (Holcomb, et al.) issued 4 August 1998, and assigned to Hewlett-Packard Company, Palo Alto, California. In this arrangement, a first decimator writes a high sample rate signal to a first section of a memory, and also directly to a second decimator that performs further decimation, and stores the resultant waveform data in a second section of the memory. This serial arrangement provides the same advantage as did the parallel arrangement in terms of decreasing the time required to draw an overview waveform image, and provides an additional advantage that much of the circuitry of the two series-coupled decimators need not be duplicated. In this regard, any decimator may be thought of as a chain of stages, and two series-coupled decimators may be realized as a single longer length chain that is tapped at an appropriate intermediate point.

All of the above-mentioned prior art is directed to solving the first problem of reducing the time required to draw a low-resolution overview record. None of them address the second problem of reducing the amount of memory required to store the high-resolution version of the waveform.

In each of the above-mentioned prior art, a high-resolution signal is acquired over the entire record, and requires a relatively large amount of memory needed to store the high sample rate signal. That is, the time over which the low sample rate signal (i.e., overview signal) is acquired, is exactly the same as the time over which the high sample rate record (i.e., zoom record) is acquired. Another way to say this is, two complete waveforms are acquired, one at a low sample rate, and one at a high sample rate, where both waveforms encompass the same time period.

What is needed is a method and apparatus for quickly displaying a low resolution (i.e., low sample rate) overview signal, while providing the ability to acquire and display a smaller portion of the waveform at high resolution (i.e., a high sample rate), avoiding the necessity of saving the entire high data rate waveform in a long record length memory.

### Summary of the Invention

A dual timebase feature for digital storage oscilloscope includes an A/D converter for producing digital samples of a signal under test. The digital samples are applied to a first decimator for decimating the samples. A second decimator coupled to the output of the first decimator further decimates the samples. A pair of gates selectively couples the outputs of the first and second decimators to a memory. A controller controls one gate to select a high data rate record having a length shorter than an entire data record for storage in memory and for display as a zoom (i.e. detailed) record, and controls the other gate to select a low data rate record encompassing substantially all of said entire data record, for display as an overview record. The subject apparatus produces two data records of different data rates and encompassing different time periods.

### Brief Description of the Drawing

FIGURE 1 is a simplified block diagram showing a single decimation arrangement as known from the prior art.
FIGURE 2 is a simplified block diagram showing a parallel decimation arrangement as known from the prior art.
FIGURE 3 is a simplified block diagram showing a serial decimation arrangement as known from the prior art.
FIGURE 4 is a simplified block diagram showing a serial decimation embodiment of the subject invention.
FIGURE 5 is an illustration of waveforms that would be produced by the decimation arrangements of FIGURES 2 and 3.
FIGURE 6 is an illustration of waveforms that would be produced by the decimation arrangement of FIGURE 4, and that are useful in understanding the invention.

### Detailed Description of the Drawing

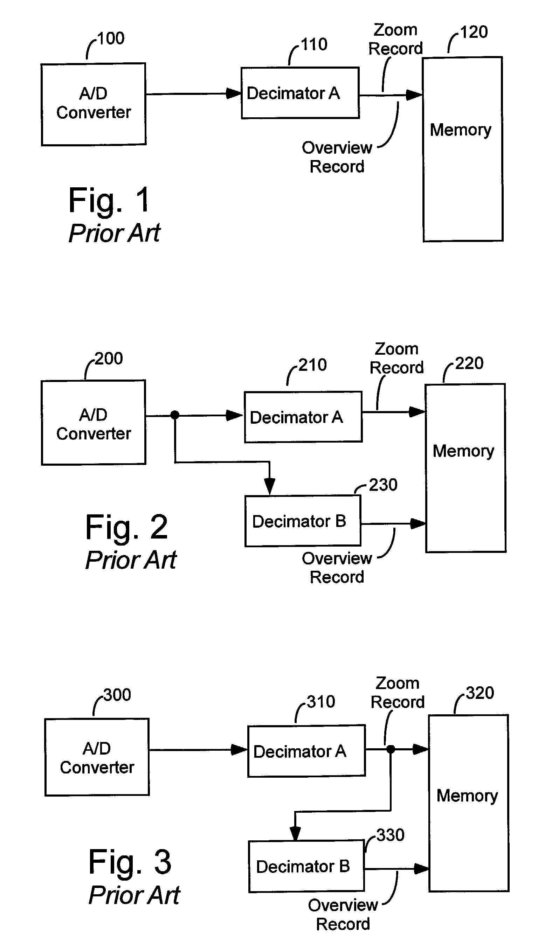

Similarly numbered elements in FIGURES 1 through 4 represent similar elements, which need not be described again in detail. Referring to prior art FIGURE 1, an A/D converter **100** applies digital samples of a signal under test to an input terminal of a Decimator **110**. Decimator **110** decimates the input signal (i.e., produces an output signal at a lower sample rate than the signal at its input), and applies it to a memory **120**. The signal sample data stored in memory **120** is used to draw both the overview record and the zoom record, resulting in slow drawing speed for the overview record due to the amount of time required to condense the stored high resolution data to the far lesser amount of data needed to display a low-resolution overview signal.

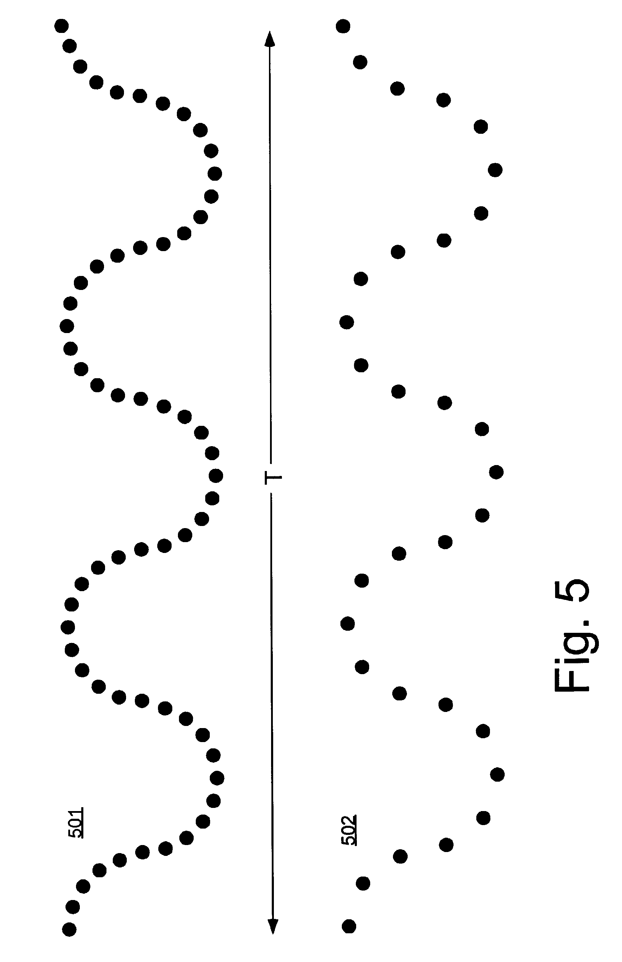

As noted above, the prior art apparatus of Figure 2 is directed to correcting the speed problem exhibited by the apparatus of Figure 1. That is, the apparatus of FIGURE 2 applies data from A/D converter **200** directly to the inputs of Decimator **210** and Decimator **230**, simultaneously. Decimator **210** produces the detailed high sample rate waveform data, and Decimator **230** is set to a higher decimation rate in order to produce a lower resolution overview record. Note that each decimator selects samples from the entire record presented to it. As expected, the signal produced by the Decimator **230**, contains fewer samples than does the signal produced by the Decimator **210**. This point is illustrated by the waveforms of FIGURE 5. Signal samples of a first waveform (generally designated **501**) produced by decimator **210**, are represented by a plurality of dots. Waveform **501** extends over time **T**. A second waveform (generally designated **502**) has been decimated by a factor of 2 greater than the first waveform. That is, every other sample of the waveform has been discarded. Thus, waveform **502** has fewer samples than does waveform **501**, but note that both waveforms still extend over the full time period **T**. Unfortunately, parallel arrangements of decimators, such as shown in FIGURE 2, may not be cost effective, due to the duplication of circuitry.

The prior art apparatus of Figure 3 corrects this problem via a different approach, serial decimation. The apparatus of FIGURE 3 stores the first decimated data from Decimator **310** and simultaneously applies that data directly to the input of Decimator **330** for further decimation. As in the apparatus of FIGURE 2, each decimator selects samples from the entire record presented to it. Again, as expected, the signal produced by the cascaded decimator, Decimator **330**, contains fewer samples than does the signal produced by the first decimator, Decimator **310**. This point is illustrated by the waveforms of FIGURE 5, as described above. Once again, it is important to note that in the operation of the apparatus of FIGURE 3, waveform **502** has fewer samples than does waveform **501**, and both waveforms still extend over the full time period **T**.

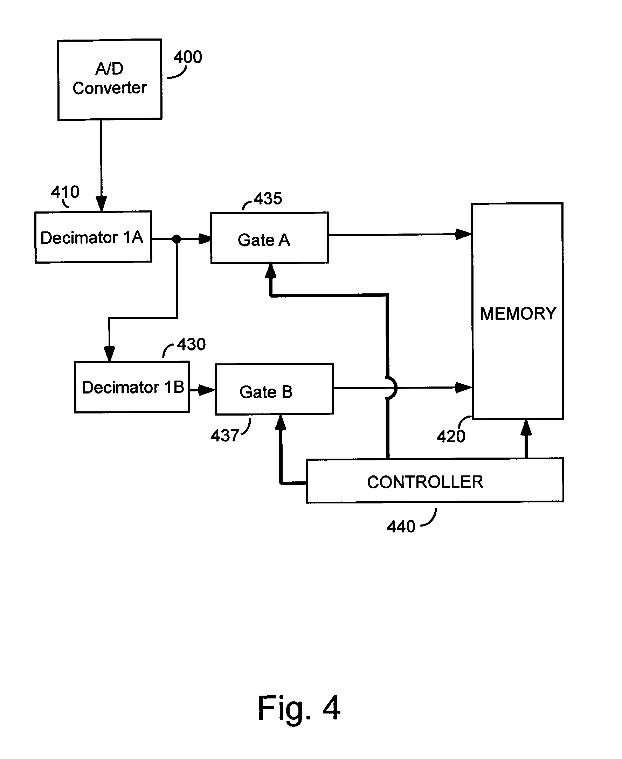

While the architecture of the series-coupled decimators **410**, **430** of FIGURE 4 (i.e., decimators (1A and 1B) looks similar to the arrangement of FIGURE 3, the circuits operate very differently. In FIGURE 4, it is important to note that, a controller **440** controls the operation of gates **435**, **437** (i.e., a suitable form of electronic switch) and memory **420** to store the proper amount of samples for each path for a given task.

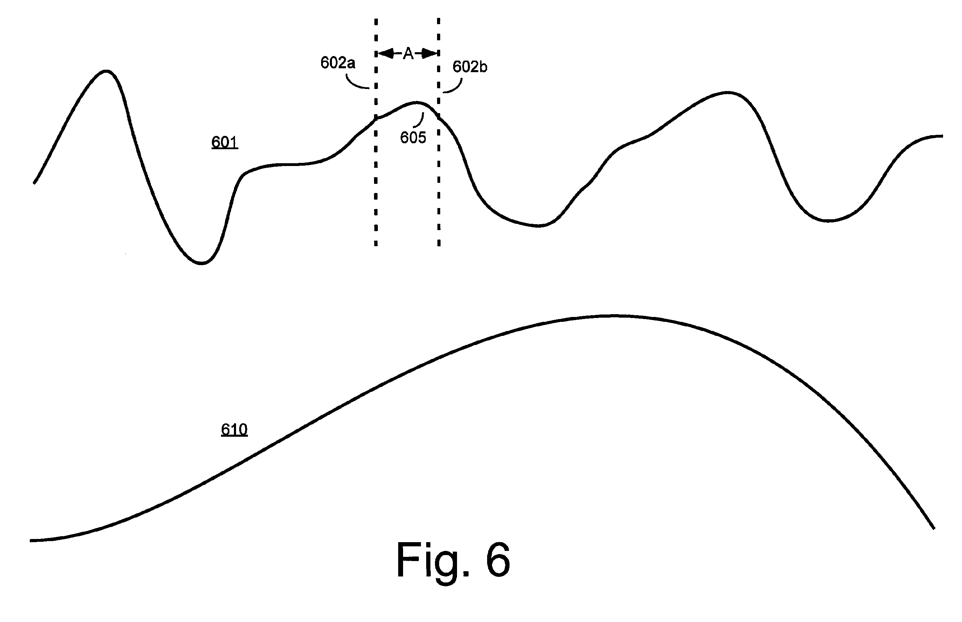

In operation, Decimator 1A **410** decimates the incoming signal and stores only a portion of it in memory **420** via a first gate circuit **435**. Note that operation of gate **435** causes samples to be taken from less than the whole record length for storage in memory (as shown in FIGURE 6). This produces a high-resolution representation of a short length of the record. In contrast to FIGURE 3, the stored output from the Decimator 1A **410**, generally has many fewer samples than does the stored output of the cascaded Decimator 1B **430**.

In this regard, it should also be noted that the stored output from the first decimator **410** cannot be used to pan and zoom over the entire data record because it does not contain a representation of the entire data record (as does the output from the first decimator of prior art FIGURE 3). However, it is herein recognized that when the operator is looking at live data in real time, he need only select a portion of the waveform that interests him, for display of a high resolution "zoom" image of that area. There is no need to store a high-resolution representation of data that does not interest him (i.e., the remainder of the waveform).

Although only a subset of the output signal of Decimator 1A **410** is stored in memory **420**, Decimator 1B **430** does receive the entire output signal of Decimator 1A **410** (a first-decimated representation of the entire record) and further decimates it for storing in memory **420**, and for display as an overview record. Thus, the stored output of Decimator 1B **430** is at a lower resolution than that stored by Decimator 1A **410**, and is a representation of the signal along the entire length of the record.

FIGURE 6 may be a screen display of an oscilloscope employing apparatus according to the subject invention. A first waveform (generally designated **601**) represents a displayed portion of an overview of an acquired (and twice decimated) record. As such, it may be, for example, the output of Decimator 1B **430** of FIGURE 4. A pair of cursors **602a** and **602b** has been positioned to define an area of interest A in waveform **601**, encompassing a waveform segment **605**. Waveform **610** represents a detailed zoom display of waveform segment **605**. Waveform **610** may be, for example, the output of Decimator 1A **410** of FIGURE 4. In that case, decimators **410**, and **430** decimate at the appropriate respective rates for the task at hand, and controller **440** controls gate **435** and memory **420** to store the appropriate amount of samples (i.e., the appropriate sub-record length acquired over a shorter period of time than the entire record).

What has been described is an implementation of a true dual timebase digital storage oscilloscope. The dual timebase feature is provided by apparatus that allows the capture and display of an overview record at a low sample rate over the entire data record, and a zoom record at a high data rate record over less than the entire period of the overview record. Use of the subject invention solves both problems evident in the prior art. It reduces the time required to draw of an overview record, and results in significantly reduced memory requirements as compared to the prior art.

Although two decimators in series have been shown for simplicity of explanation, one skilled in the art will realize that a single longer length decimator, tapped at an intermediate point, may be used in place of the illustrated two shorter ones. One skilled in the art will realize that any decimator could actually be implemented as two sub-decimators coupled in series, because decimators, in general, comprise a series arrangement of stages. The sub-decimators may, or may not, decimate according to the same decimation scheme.

It is herein recognized that if one always wants to store a low resolution representation of the entire waveform (i.e., never less than the entire waveform) in memory **440**, then Gate B **437** of FIGURE 4 may be removed, with the signal from the second decimator **430** being applied directly to memory **440**, and such modification is deemed to lie within the scope of the following claims.

## Claims

1. A dual timebase digital storage oscilloscope, comprising:
an A/D converter for producing digital samples of a signal under test;
a first decimator having an input coupled to an output of said A/D converter for receiving and decimating said samples;
a second decimator having an input coupled to an output of said first decimator for receiving said decimated samples and further decimating said decimated samples;
a first gate having an input coupled to an output of said first decimator, and an output;
a second gate having an input coupled to an output of said second decimator, and an output;
a memory coupled to said outputs of said gates for receiving and storing signal; samples; and
a controller for controlling said first gate to couple a high data rate record having a length shorter than an entire data record to said memory, and controlling said second gate to couple a low data rate overview record of substantially all of said entire data record to said memory.

2. The dual timebase oscilloscope of claim 1 wherein:
said high data rate record is produced by said first decimator.

3. The dual timebase oscilloscope of claim 1 wherein:
said low data rate overview record is produced by said second decimator.

4. The dual timebase oscilloscope of claim 1 wherein:
said low data rate overview record contains more samples than said high data rate record.

5. The dual timebase oscilloscope of claim 1 wherein:
said high data rate record is a zoom record

6. A dual timebase digital storage oscilloscope, comprising:
an A/D converter for producing digital samples of a signal under test;
a decimator having an input coupled to an output of said A/D converter for receiving and decimating said samples and producing said first decimated samples at a first output;
said decimator having a second output for producing further decimated samples;
a first controlled switch having an input coupled to said first output of said decimator, and an output;
a second controlled switch having an input coupled to said second output of said decimator, and an output;
a memory coupled to said outputs of said controlled switches for receiving and storing signal; samples; and
a controller for controlling said first controlled switch to couple a high data rate record having a length shorter than an entire data record to said memory, and
controlling said second controlled switch to couple a low data rate overview record of substantially all of said entire data record to said memory.

7. The dual timebase oscilloscope of claim 6 wherein:
said high data rate record is produced at said first output of said decimator,
said high data rate record being a zoom record.

8. The dual timebase oscilloscope of claim 6 wherein:
said low data rate overview record is produced at said second output of said decimator.

9. The dual timebase oscilloscope of claim 6 wherein:
said low data rate overview record contains more samples than said high data rate record.

10. A method of providing a true dual timebase feature for digital storage oscilloscope, comprising the steps of:
producing digital samples of a signal under test;
receiving and decimating said samples and producing first decimated samples;
further decimating said first decimated samples to produce further decimated samples;
storing a predetermined amount of said first decimated samples in a memory;
storing said further decimated samples in said memory;
displaying said further decimated samples as an overview record; and
displaying said stored amount of said first decimated samples as a zoom record.

11. A dual timebase digital storage oscilloscope, comprising:
an A/D converter for producing digital samples of a signal under test;
a first decimator having an input coupled to an output of said A/D converter for receiving and decimating said samples;
a second decimator having an input coupled to an output of said first decimator for receiving said decimated samples and further decimating said decimated samples;
a gate having an input coupled to an output of said first decimator, and an output;
a memory having a first input coupled to said output of said gate, and a second input coupled to an output of said second decimator, for receiving and storing signal samples; and
a controller for controlling said gate to couple a high data rate record having a length shorter than an entire data record to said memory, and controlling storage of a low data rate overview record of substantially all of said entire data record in said memory.
